# EUROPEAN PATENT SPECIFICATION

(11) **EP 3 226 342 B1**
(45) Date of publication and mention of the grant of the patent: **16.12.2020**
(21) Application number: 16163467.0
(22) Date of filing: 01.04.2016
(51) Int. Cl.: H01M 10/42, H01M 10/48, G01R 31/364, H01M 2/10, G01R 31/3835

(54) **CELL CONNECTION UNIT**
ZELLVERBINDUNGSEINHEIT
UNITÉ DE CONNEXION DE CELLULES

(43) Date of publication of application: 04.10.2017
(73) Proprietor: Samsung SDI Co., Ltd., Gyeonggi-do 17084 (KR)
(72) Inventor: Schmiedhofer, Christoph, 8020 Graz (AT)
(74) Representative: Gulde & Partner

(56) References cited:
- EP-A1- 3 065 198
- WO-A1-2014/024435
- WO-A1-2015/005147
- WO-A1-2015/064329
- US-A1- 2014 299 373
- US-A1- 2014 329 121
- US-A1- 2015 287 964
- US-A1- 2016 043 446

## Description

### Field of the Invention

The present invention relates to a battery module and, more particularly, to a battery module of an electrified vehicle. The invention relates to a battery module comprising a cell connection unit and further a method for construction of a battery module.

### Technological Background

A rechargeable battery differs from a primary battery in that it can be repeatedly charged and discharged, while the latter makes only the irreversible conversion of chemical to electrical energy. Low-capacity rechargeable batteries are used as the power supply for small electronic devices, such as cellular phones, notebook computers and camcorders, while high-capacity rechargeable batteries are used as the power supply for driving motors in hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. The case may have a cylindrical or rectangular shape depending on the purpose of the rechargeable battery. Electrolyte solution is injected into the case for charging and discharging of the rechargeable battery through an electrochemical reaction of the positive electrode, the negative electrode, and the electrolyte solution.

Rechargeable batteries may be used as a battery module formed of a plurality of unit batteries or cells coupled in series so as to be used as an energy supply with relatively high energy density. That is, the battery module is formed by connecting an electrode terminal of each of the plurality of unit batteries depending on the amount of power required such that a high-power rechargeable battery can be realized.

In order to safely use the battery module, heat generated from the rechargeable battery should be efficiently emitted, discharged and/or dissipated. If the heat emission/discharge/dissipation is not sufficiently performed, a temperature deviation occurs between the respective unit batteries, such that the battery module cannot generate a desired amount of power for motor driving. In addition, if the internal temperature of the battery is increased due to the heat generated by the rechargeable battery, an abnormal reaction occurs therein and thus charging and discharging performance of the rechargeable battery deteriorates and the life-span of the rechargeable battery is shortened.

The cells of the battery module usually are connected by a so-called "busbar", sometimes also called a "bussbar" or a "bus bar". Busbars are usually monolithic and made of solid metal, since their main function is to electrically connect the cells of the battery module with each other to transfer electrical currents between cells of the battery module.

Cell voltage and/or cell temperature of the battery module may be monitored using one or more cell monitoring controller (CMC) connected to the battery module and, more particularly, to the busbars. However, the cell monitoring controller (CMC) may either be connected directly to the battery cells or connected via a wiring harness. Thus, the packing density of the battery module is increased due to the additional electronic components required for cell voltage and temperature measurements.

Exemplary embodiments of conventional battery modules including a cell connection unit may be found in KR 2005-0048277, KR 2010-0003146 and US 2014/0017533, as well as in US 2016/043446 A1, US 2014/299373 A1, US 2015/287964 A1, US 2014/329121 A1, WO 2014/024435 A1, WO 2015/064329 A1, WO 2015/005147 A1 and EP 3 021 378 A1.

### Summary of Invention

An objective of the present invention is to provide a battery module comprising a cell connection unit , more particularly, a battery module of an electrified vehicle, wherein the additional space needed to accommodate an electronic unit such as a cell monitoring controller is reduced, and wherein the structure of the cell connection unit is simplified.

In accordance with an aspect of the present invention, there is provided a battery module comprising an electronic unit, a cell connection unit and a venting slot according to an embodiment of the present invention, wherein the electronic unit is connected to the cell connection unit via the connector portion and wherein the cell connection unit comprises at least one substrate portion, a connector portion, and an electronic circuit portion. The at least one substrate portion is adapted to accommodate the electrode terminals of the battery module. The connector portion is adapted to be connected to an electronic unit. The electronic circuit portion is adapted to provide an electrical connection between at least one of the electrode terminals of the battery module and the electronic unit via the connector portion. The connector portion comprises at least one fixed electrical connector and a plurality of fixation connectors. The at least one substrate portion comprises an opening portion adapted to accommodate the electronic unit and a venting portion, wherein the venting portion has a longitudinal shape with one end facing the opening portion. The battery module comprises a venting slot adapted to convey gas generated in the battery module to the outside of the battery module via at least one venting outlet. The venting slot extends along a longitudinal axis of the battery module and includes at least two venting outlets positioned at opposite ends of the venting slot, wherein the venting slot is formed by the opening portion and the venting portion of the cell connection unit.

The electronic unit may be a cell monitoring controller (CMC).

The electronic unit may comprise a substrate and at least one electronic component, wherein each one of the at least one electronic component of the electronic unit may be arranged on one side of the substrate which faces the cell unit of the battery module.

At least one of the fixed electrical connectors and the plurality of fixation connectors may be press-fit connectors.

At least one of the fixed electrical connectors and the plurality of fixation connectors may be pin connectors.

The cell connection unit may further comprise at least one contact portion adapted to be electrically connected to the at least one of the cell terminals of the battery module, wherein the at least one electronic circuit portion may be adapted to electrically connect the at least one contact portion of the battery module with the at least one fixed press-fit electrical connector.

The electronic circuit portion may be a built-in lead frame portion of the cell connection unit. The at least one substrate portion may be one piece formed of the (mould) material which includes the lead frame portion.

At least a part of the at least one substrate portion may exceed the connector portion along a direction perpendicular to a plane of main extension of the cell connection unit.

In accordance with another aspect of the present disclosure, there is provided a method for construction of a battery module, comprising the steps of: providing a cell connection unit according an embodiment of the present invention, assembling at least one busbar unit to the at least one substrate portion of the cell connection unit, and joining the cell connection unit to a cell unit to form the assembled battery module.

The method may further comprise the step of connecting the electronic unit to the cell connection unit.

Further benefits and advantages of the present invention will become apparent after a careful review of the detailed description and the accompanying drawings.

### Brief Description of the Drawings

In the drawings, same element numbers indicate same elements in each of the figures:
- Fig. 1: is a perspective view of a conventional battery module.
- Fig. 2: is a perspective view of a battery module in accordance with a preferred embodiment of the present invention.
- Fig. 3: is a locally enlarged and exploded view of the battery module shown in Fig. 2.
- Fig. 4: is a non-exploded perspective view of the battery module shown in Fig. 3.
- Fig. 5: is a schematic front view of a battery module in accordance with a preferred embodiment of the present invention.
- Fig. 6: is a perspective top view of a cell connection unit in accordance with a preferred embodiment of the present invention.
- Fig. 7: is a perspective bottom view of the cell connection unit shown in Fig. 6.
- Fig. 8: is a plan cross-sectional view of a cell connection unit in accordance with a preferred embodiment of the present invention.

### Detailed Description of the Invention

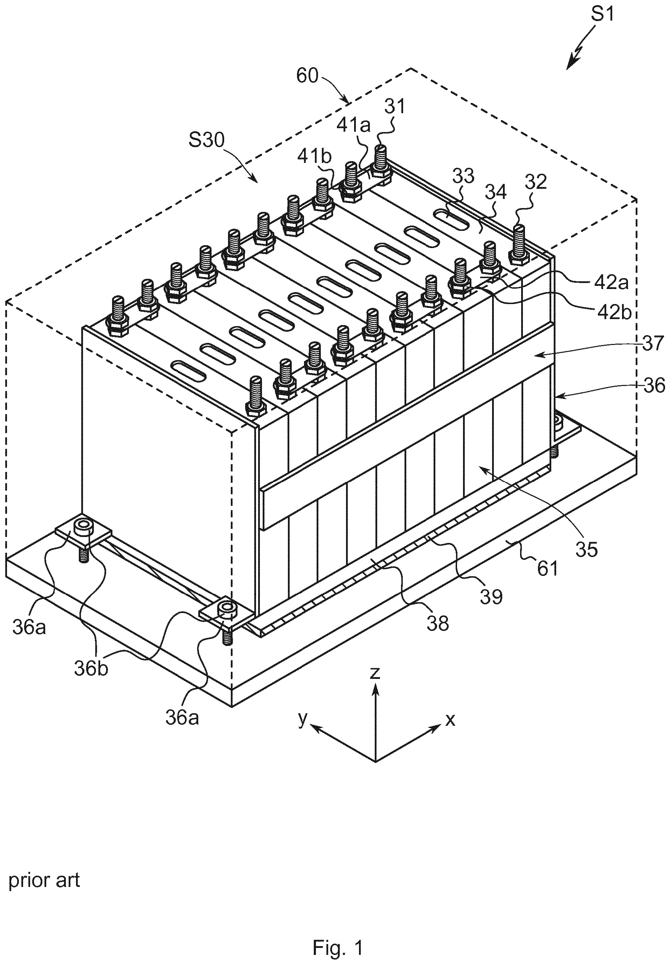

Referring to the drawings and initially to Fig. 1, an exemplary embodiment of a conventional battery module S1 includes a plurality of battery cells 35 aligned in one direction and a heat exchange member 38 adjacent to a bottom surface of the plurality of battery cells 35. A pair of endplates 36 are provided to face wide surfaces of the battery cells 35 at the outside of the battery cells 35, and a connection plate 37 is configured to connect the pair of end plates 36 to each other thereby fixing the plurality of battery cells 35 together. Fastening portions 36a on both sides of the battery module S1 are fastened to a support plate 61 by bolts 36b. The support plate 61 is part of a housing 60 of the battery module S1.

As shown, each battery cell 35 is a prismatic (or rectangular) cell, the wide flat surfaces of the cells stacked together to form a cell unit S30 of the battery module S1. Further, each battery cell 35 includes a battery case configured to accommodate an electrode assembly and an electrolyte. The battery case is hermetically sealed by a cap assembly 34. The cap assembly 34 is provided with positive and negative electrode terminals 31 and 32 having different polarities, and a vent 33. The vent 33 is a safety means of the battery cell 35 which acts as a passage way for gas being generated in the battery cell 35 to be discharged to the outside of the battery cell 35. The positive and negative electrode terminals 31 and 32 of neighboring battery cells 35 are electrically connected through a busbar 41a, 42a, respectively. The busbar 41a, 42a may be fixed by a fastening portion 41b, 42b, for example a nut or the like. Hence, the battery module S1 may be used as power source unit comprising an electrically connected bundle of the plurality of battery cells 35.

Generally, the battery cells 35 generate a large amount of heat while being charged/discharged. The generated heat is accumulated in the battery cells 35, thereby accelerating the deterioration of the battery cells 35. Therefore, the battery module S1 further includes a heat exchange member 38, which is provided adjacent to the bottom surface of the battery cells 35 so as to cool down the battery cells 35. In addition, an elastic member 39 made of rubber or other elastic materials may be interposed between the support plate 61 and the heat exchange member 38.

The heat exchange member 38 may include a cooling plate. The cooling plate may have a size corresponding to that of the bottom surface of the plurality of battery cells 35, e.g., the cooling plate may completely overlap the entire bottom surfaces of all the battery cells 35 in the battery module S1. The cooling plate usually includes a passage way through which a coolant may move. The coolant performs a heat exchange with the battery cells 35 while circulating inside the heat exchange member 38, i.e., inside the cooling plate.

The probes for cell voltage measurements of the battery module 1 may be realized by a wiring harness which connects the electrode terminals 31, 32 with a cell monitoring controller, CMC. However, a wiring harness may typically be screwed or welded to the electrode terminals 31, 32 in order to get contact to the electrode terminals 31, 32. The wiring harness may get connected to the CMC via a plug. Thus, the vent 33 of each battery cell 35 which conveys the gas to the outside of the battery module 1 may be obstructed by the wiring harness. It has been observed that the use of the wiring harness may lead to a short circuit within the battery module S1. Moreover, manual work may be required to connect the CMC via the wiring harness to the battery module S1.

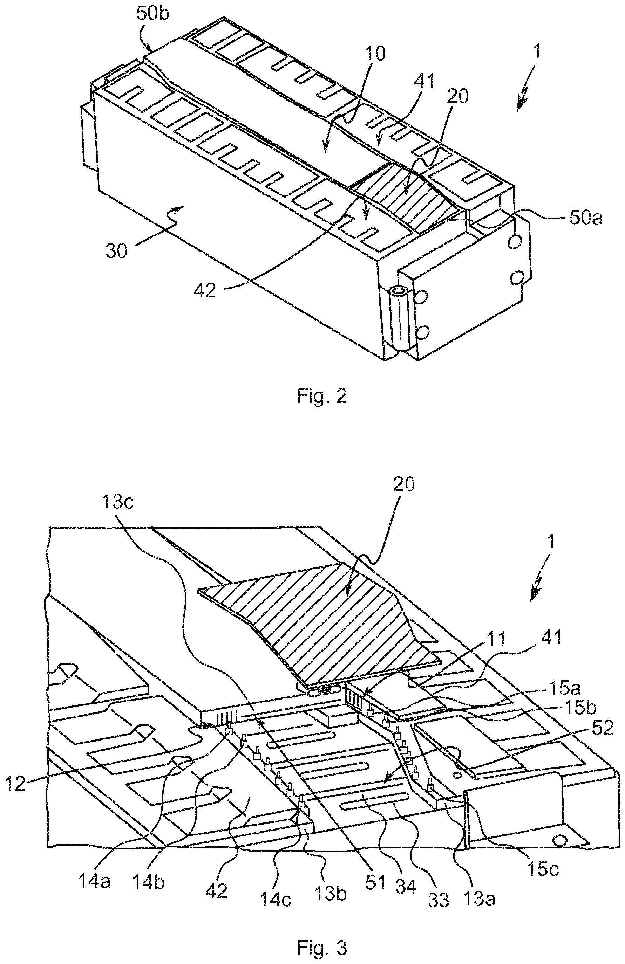

Referring to Fig. 2, a battery module 1 in accordance with a preferred embodiment of the present invention comprises a cell connection unit 10 (CCU 10) and an electronic unit 20. The battery module may further comprise a cell unit 30 which may be similar to the cell unit illustrated in Fig. 1. However, instead of providing separate components for busbar holder and wiring harness, the CCU 10 may combine several features into one component: a carrier for busbar units 41, 42, a carrier for the electronic unit 20, as well as an electrical connection and fixation of the electronic unit 20 to the cell connection unit via press-fit technology, as will be described in greater detail below. Here, the CCU 10 is a component disposed between the cell unit 30 and the CMC electronic unit 20.

As shown, the battery module 1 has two venting outlets 50a, 50b disposed at opposite sides of the battery module 1. That is, the battery module 1 mainly extends along a longitudinal direction which corresponds to the stacking direction of the cells. The venting outlets 50a, 50b are in fluid communication via a venting passage which mainly extends centrally along the longitudinal direction of the battery module 1. The venting outlets 50a, 50b allow for conveying gas produced by the cells. At least a part of the venting passage is arranged below the electronic unit 20 such that a space-saving structure is provided.

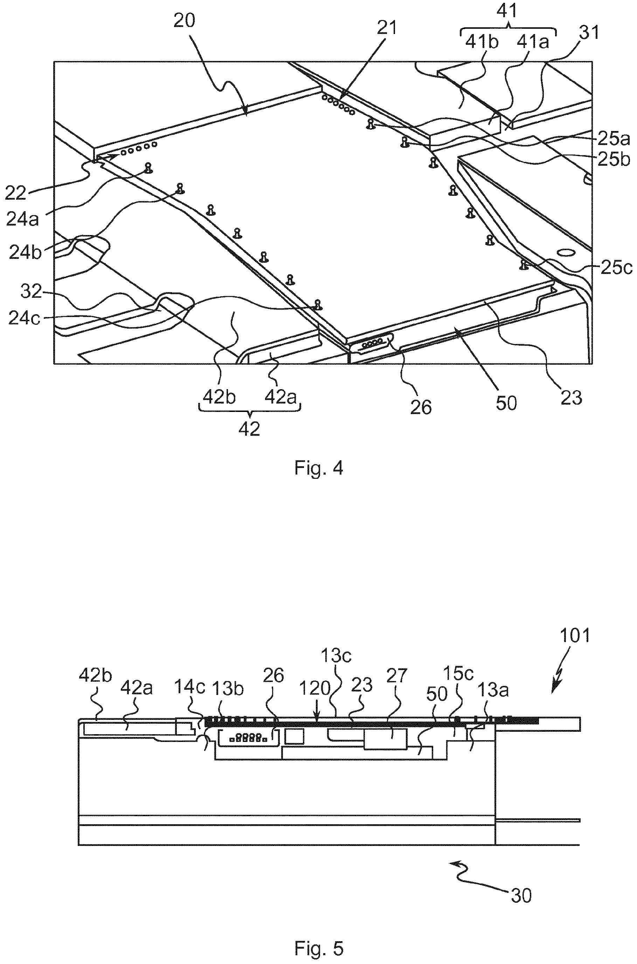

Fig. 3 is a locally enlarged and exploded view of the battery module of Fig. 2, wherein a cell connection unit 10 according to an embodiment of the present invention is shown. The cell connection unit 10 comprises at least one substrate portion 13a, 13b, 13c adapted to accommodate cell terminals 31, 32 of the battery module 1. More particularly, the at least one substrate portion 13a, 13b, 13c is adapted to accommodate the electrode terminals 31, 32 of the cell unit 30 (which can be seen in the enlarged view of Fig. 4). The cell connection unit 10 is further adapted to accommodate the busbar units 41, 42 which are adapted to electrically connect two or more of the cell terminals 31, 32 of the battery module 1. That is, the cell connection unit 10 is a busbar holder, wherein the side portions 13a, 13b of the at least one substrate portion 13a, 13b, 13c is a carrier holding the busbar units 41, 42.
The cell unit 30 further comprises a vent 33 and a cap assembly 34 which hermetically seals the battery case. The cap assembly 34 is provided with the vent 33. The vent 33 is a safety means of the battery cell unit 30 which acts as a passage way for gas being generated in the battery cell to be discharged to the outside of the battery cell. A first and a second venting slot portion 51, 52 are adapted to merge the gas collected from each one of the battery cells of the cell unit and to guide the gas to the outside of the battery module 1. The first venting slot portion 51 extends below the central substrate portion 13c and along a flow path between the cell connection unit 10 and the cell unit 30. The second venting slot portion 52 is arranged below the electronic unit 20 when the electronic unit 20 is connected to the cell connection unit 10. Thus, the battery module 1 - and, more particularly, a bottom portion of the cell connection unit 10 and a top portion of the cell unit 30 - is/are adapted such that the second venting slot portion 52 is formed below the electronic unit 20 when the electronic unit 20 is connected to the cell connection unit 10.

The cell connection unit further comprises a connector portion 11, 12, 14a, 14b, 14c, 15a, 15b, 15c adapted to be connected to an electronic unit 20. The connector portion 11, 12, 14a, 14b, 14c, 15a, 15b, 15c comprises at least one fixed electrical connector 11, 12 and a plurality of fixation connectors 14a, 14b, 14c, 15a, 15b, 15c. As shown, the plurality of fixation connectors 14a, 14b, 14c, 15a, 15b, 15c includes a first fixation connector array 14a, 14b, 14c, and a second fixation connector array 15a, 15b, 15c to provide a mechanically stable connection of the electronic unit 20 to the cell connection unit 10. The first and second fixation connector arrays 14a, 14b, 14c, 15a, 15b, 15c are arranged at opposite sides or lateral edges of the electronic unit 20. The at least one of the fixed electrical connectors 11, 12 and the plurality of fixation connectors 14a, 14b, 14c, 15a, 15b, 15c are connector plugs, which are here shown as press-fit pin connectors. The CCU 10 may be an over-moulded lead frame adapted to electrically connect the cell terminals 31, 32 and the electronic unit 20. The press-fit technology allows a simple attachment of the electronic unit 20 with the benefit that the press-fit pins 11, 12 are connected to the cell voltage signals portions which may be used for cell temperature and/or voltage measurement. The press-fit pins 14a, 14b, 14c, 15a, 15b, 15c along the lateral edges of the electronic unit 20 are adapted to stabilize the electronic unit 20 with respect to the cell connection unit 10.

Fig. 4 is a non-exploded perspective view of the battery module shown in Fig. 3. As shown, the electronic unit 20 is connected to the cell connection unit 10 via the connector portion 11, 12, 14a, 14b, 14c, 15a, 15b, 15c. The electronic unit 20 may be a printed circuit board (PCB) attached to the CCU 10 without any screw or moulded plastic clip. The simple fixation may allow for a reduction of production costs as compared to the known structures. The electronic unit 20 comprises a substrate 23 which mainly extends along a plane, thereby forming an electronic board. The electronic unit 20 may be a printed electronic board and, more particularly, a cell monitoring controller. The electronic unit 20 may comprise a bus connector 26 adapted for data communication with an external device (not shown).

The electronic unit 20 comprises a further connector portion 21, 22, 24a, 24b, 24c, 25a, 25b, 25c adapted to be connected to the connector portion 11, 12, 14a, 14b, 14c, 15a, 15b, 15c of the cell connection unit 10. That is, the further connector portion 21, 22, 24a, 24b, 24c, 25a, 25b, 25c of the electronic unit 20 and the connector portion 11, 12, 14a, 14b, 14c, 15a, 15b, 15c of the cell connection unit 10 are mating connector portions. The further connector portion 21, 22, 24a, 24b, 24c, 25a, 25b, 25c comprises at least one electrical connector socket 21, 22 adapted to electrically connect to the fixed electrical connector plugs 11, 12 and a plurality of fixation connector sockets 24a, 24b, 24c, 25a, 25b, 25c adapted to mechanically connect to the fixation connector plugs 14a, 14b, 14c, 15a, 15b, 15c of the cell connection unit 10. More particularly, the further connector portion 21, 22, 24a, 24b, 24c, 25a, 25b, 25c may comprise a plurality of connector holes 21, 22, 24a, 24b, 24c, 25a, 25b, 25c adapted to connect to the press-fit pin connectors of the cell connection unit 10.

As shown, the electronic unit 20 comprises two electrical connector sockets 21, 22 and, more particularly, bus connector sockets. The cell connection unit 10 comprises two electrical connector plugs 11, 12 and, more particularly, bus connector plugs. The bus connector plugs 11, 12 and bus connector sockets 21, 22 are connected to each other via a press-fit technology. Likewise, the fixation connector sockets 24a, 24b, 24c, 25a, 25b, 25c comprise a first fixation connector socket array 24a, 24b, 24c and a second fixation connector socket array 25a, 25b, 25c.

When the electronic unit 20 is connected to the battery module 1, the venting slot 50 is formed which comprises the venting outlets 50a, 50b at the respective ends, as shown in Fig. 2. The venting slot 50 centrally extends along a longitudinal direction of the battery module 1 and comprises the first and second venting portions 51, 52 described above.

As further shown, the cell connection unit 10 holds at least one busbar unit 41, 42 which electrically connects the cell terminals 31, 32, respectively.

Referring to Fig. 5, a battery module 101 in accordance with a preferred embodiment of the present invention may correspond to the other embodiments described above. The electronic unit 120 further comprises at least one electronic component 27 which is arranged on one side of the substrate 23 which faces the cell unit 30 of the battery module 1. The electronic components 27 are populated on the bottom side of the PCB 20 in order to decrease the total height of the assembly and use the available space below the electronics. The venting slot 50 comprises a cavity of the CCU 10 positioned below the PCB 20, wherein the cavity may have the functionality to provide enough space to accommodate the electronic components 27 without obstructing other parts of the venting slot 50. Here, "enough space" relates to an amount of space which is sufficient to form the venting portion 52 for the venting slot 50 below the CMC 20 such that the venting slot 50 allows for fluid communication between the venting outlets 50a, 50b.

Fig. 5 illustrates the utilization of the available space by the CMC 20. As shown, the press-fit pins 14c, 15c are located between the busbars 41, 42.As further shown in Fig. 5, the at least one substrate portion 13a, 13b, 13c comprises a central portion 13c of the substrate which connects the side portions 13a, 13b of the substrate. The central portion 13c exceeds the side portions 13a, 13b in a vertical direction. The central portion 13c further exceeds the electronic unit 20 in the vertical direction. The cell connection unit 10 mainly extends along a plane which is perpendicular to the vertical direction. Thus, a relatively high shock resistance with respect to mechanical impacts and a relatively high packing density can be achieved.

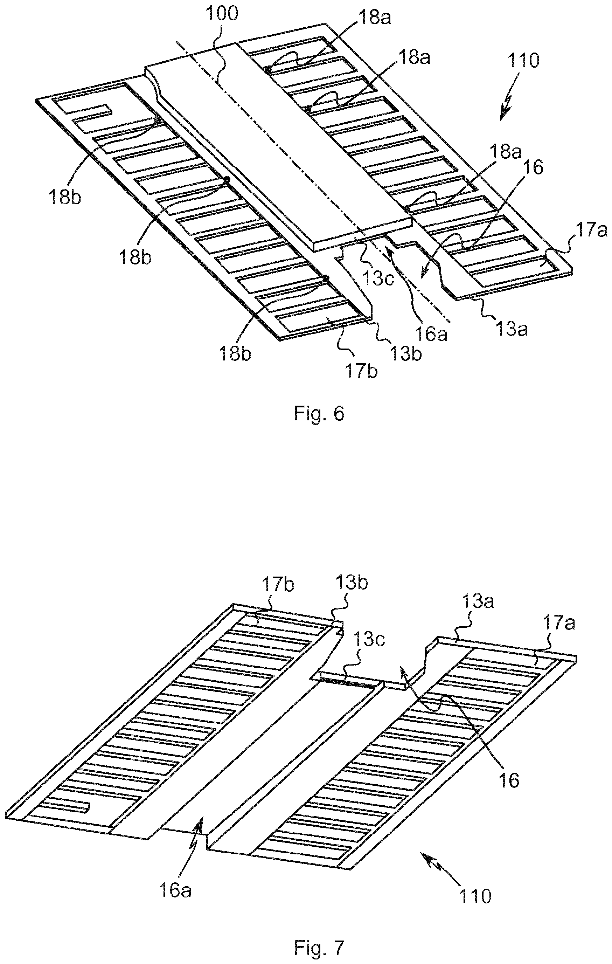

Referring to Fig. 6, a cell connection unit 110 in accordance with a preferred embodiment of the present invention may correspond to the other embodiments described above. The at least one substrate portion 13a, 13b, 13c of the cell connection unit 110 comprises an opening portion 16 adapted to accommodate the electronic unit 20 and a venting portion 16a. The venting portion 16a has a longitudinal shape with one end facing the opening portion 16. The at least one substrate portion 13a, 13b, 13c may comprise the centrally arranged substrate portion 13c which includes the venting portion 16a extending along a longitudinal axis 100 of the cell connection unit 110.

As further shown, the at least one substrate portion 13a, 13b, 13c comprises terminal openings 17a, 17b adapted to accommodate the cell terminals 31, 32 of the cell unit 30. The cell connection unit 110 further comprises at least one contact portion 18a, 18b and, more particularly at least one contact pad 18a, 18b, adapted to be electrically connected to the at least one of the cell terminals 31, 32 of the battery module 1. The contact portion 18a, 18b may be provided for voltage and/or temperature measurements of the battery cells. Fig. 7 is a perspective bottom view of the cell connection unit 110 shown in Fig. 6. The venting portion 16a is a recess of the central substrate portion 13c. The venting portion 16a and the central substrate portion 13c both centrally extend along the longitudinal axis 100 of the cell connection unit 110 to form the first venting portion 51 described above.

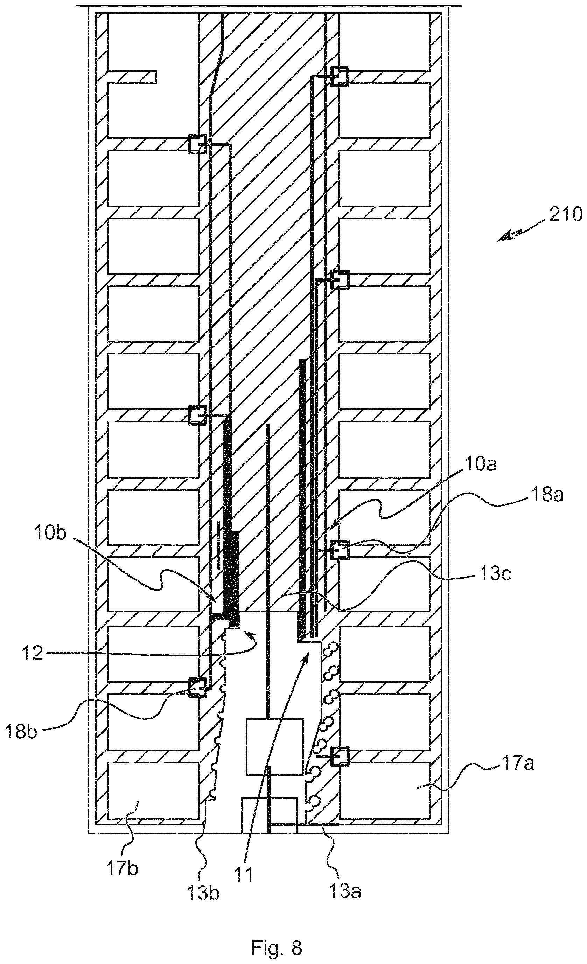

Referring to Fig. 8, a cell connection unit 210 in accordance with a preferred embodiment of the present invention comprises an electronic circuit portion 10a, 10b adapted to provide an electrical connection between at least one of the cell terminals 31, 32 of the battery module 1 and the electronic unit 20 via the connector portion 11, 12 and, more particularly, via the fixed electrical connectors 11, 12. The at least one electronic circuit portion 10a, 10b is adapted to electrically connect the at least one contact portion 18a, 18b of the battery module 1 with the at least one fixed press-fit electrical connector 11, 12. The electronic circuit portion 10a, 10b is shown as a built-in lead frame portion of the cell connection unit 10.

In summary, according to an aspect of the present invention, there is provided a cell connection unit for a battery module, comprising at least one substrate portion adapted to accommodate cell terminals of the battery module, a connector portion adapted to be connected to an electronic unit, an electronic circuit portion adapted to provide an electrical connection between at least one of the cell terminals of the battery module and the electronic unit via the connector portion, wherein the connector portion comprises at least one fixed electrical connector and a plurality of fixation connectors.

The electronic unit may be a control unit and, more particularly, a cell monitoring control unit, CMC, adapted for at least one of cell voltage measurements and temperature measurements of at least one battery cell of the battery module. The connector portion may be adapted to be connected to the electronic unit via the at least one fixed electrical connector and via the plurality of fixation connectors. That is, the electronic unit may be electrically connected to the cell connection unit via the fixed electrical connector. The electronic unit may be further mechanically connected to the cell connection unit via the fixation connectors. A fixed electrical connector - in accordance with embodiments of the present invention - may be any electrical connector immovably fixed relative to the at least one substrate portion of the cell connection unit.

By providing the fixed electrical connectors, a defined routing of the cables for cell voltage measurement may be provided. Thus, it may be safe to avoid using a wiring harness which may obstruct a venting channel of the battery module in case of a defect cable-fixation which may lead to a short circuit. Moreover, in contrast to manually fixing the flexible wiring harness, the electronic unit may be fixed in an automatic process.

The at least one substrate portion may be adapted to accommodate at least one busbar unit. Thus, the cell connection unit may be a module which integrates a busbar holder and the functionality of a wiring harness in one component.

At least one of the fixed electrical connectors and the plurality of fixation connectors may be press-fit connectors. That is, either only the at least one fixed electrical connector may be a press-fit connector, or only the plurality of fixation connectors may be press-fit connectors, or both the at least one fixed electrical connector and the plurality of fixation connectors may be press-fit connectors. At least one of the fixed electrical connectors and the plurality of fixation connectors are pin connectors. That is, either only the at least one fixed electrical connector may be a pin-connector, or only the plurality of fixation connectors may be pin-connectors, or both the at least one fixed electrical connector and the plurality of fixation connectors may be pin-connectors. The electronic unit may be an electronic board directly fixed to the CCU without screws or plastic clips. A press-fit technology may be used for conduction of cell voltage signals and fixation of the CMC.

The cell connection unit may further comprise at least one contact portion adapted to be electrically connected to the at least one of the cell terminals of the battery module, wherein the at least one electronic circuit portion may be adapted to electrically connect the at least one contact portion of the battery module with the at least one fixed press-fit electrical connector. The at least one contact portion may be a contact pad. The electronic circuit portion may be a built-in lead frame portion of the cell connection unit. The at least one substrate portion may be one piece formed of the same material which includes the lead frame portion. The cell connection unit may comprise or be an over-moulded lead frame (CCU) which requires no additional plug or interface because all plugs are moulded into the CCU.

The at least one substrate portion comprises an opening portion adapted to accommodate the electronic unit and a venting portion, wherein the venting portion has a longitudinal shape with one end facing the opening portion. Thus, multiple venting gas outlets provide a defined gas path. The lead frame may be routed around the venting-outlets, i.e. at least not routed above the venting-outlets, which may improve the safety of the battery module.

At least a part of the at least one substrate portion may exceed the connector portion along a direction perpendicular to a plane along which the cell connection unit mainly extends. This means, that the CMC may be kept out of a crash area, thereby improving the shock resistance of the battery module.

In accordance with an aspect of the present invention, there is provided a battery module comprising an electronic unit and a cell connection unit according to an embodiment of the present invention, wherein the electronic unit is connected to the cell connection unit via the connector portion.

The electronic unit may be a printed electronic board (PCB) and, more particularly, a PCB controller. The electronic unit may be a cell monitoring controller (CMC). The electronic unit may comprise a substrate. The substrate may mainly extend along a plane having a first side and a second side opposite the first side. The electronic unit may comprise at least one electronic component, wherein each one of the at least one electronic component of the electronic unit may be arranged on the same one side of the substrate which faces the cell unit of the battery module, for example the first side. The electronic unit may comprise at least one further electronic component arranged on the first side of the electronic unit. The at least one electronic component, the at least one further electronic component and all other electronic components of the electronic unit may be arranged on the same (first) side of the substrate. The electronic unit may be an electronic board located on top of the over-moulded lead frame (CCU), thereby providing a space-saving solution. One of the highest possible packaging densities may thereby be provided in a top region of the battery module. This may provide more space and a higher energy density of the battery module.

The battery module comprises a venting slot adapted to convey gas generated in the battery module to the outside of the battery module via at least one venting outlet.

The venting slot extends along a longitudinal axis of the battery module and includes at least two venting outlets positioned at opposite ends of the venting slot. The venting slot is formed by the opening portion and the venting portion of the cell connection unit. That is, the venting slot may comprise the venting portion and a top surface of a cell unit to which the cell connection unit is attached. Thus, multiple venting gas outlets may provide a defined gas path. The venting slot may provide a merged venting channel for all cells in the battery module. A gas outlet may at least be provided at the front side of the battery module.

In accordance with an aspect of the present invention, there is provided a method for construction of a battery module, comprising the steps of: providing a cell connection unit in accordance with embodiments of the present invention, assembling at least one busbar unit and the at least one substrate portion of the cell connection unit, and joining the cell connection unit and a cell unit to form the assembled battery module. The at least one busbar unit may be connected to the at least one substrate portion of the cell connection unit prior to joining the cell connection unit and a cell unit to form the assembled battery module. Likewise, the electronic unit may be connected to the cell connection unit prior to or subsequent to joining the cell connection unit to a cell unit to form the assembled battery module. Thus, the battery module may be constructed without requiring manual work (for example a fully automated construction) because the attachment of the wiring harness may be omitted and the CCU and busbars can be pre-assembled before they are mounted to the cell-pack.

Although the invention has been explained in relation to its preferred embodiment(s) as described above, it is to be understood that many other possible modifications and variations can be made without departing from the scope of the present invention. It is, therefore, contemplated that the appended claim or claims will cover such modifications and variations that fall within the scope of the invention.

### Reference Numbers

- 1, 101, S1: Battery module
- 10, 110, 210: Cell connection unit
- 10a, 10b: Electronic circuit portion / lead frame portion
- 11, 12: Fixed electrical connector plugs / connector portion
- 13a, 13b, 13c: Substrate portions
- 14a, 14b, 14c: Fixation connector plugs / connector portion
- 15a, 15b, 15c: Fixation connector plugs / connector portion
- 16: Opening portion
- 16a: Venting portion
- 17a, 17b: Terminal openings
- 18a, 18b: Contact portions
- 20, 120: Electronic unit / cell monitoring controller
- 21, 22: Electrical connector sockets
- 23: Substrate / electronic board
- 24a, 24b, 24c: Connector socket
- 25a, 25b, 25c: Connector socket array
- 26: Connector plug
- 27: Electronic component
- 30, S30: Cell unit
- 31, 32: Cell terminals / electrode terminals
- 33: Vent
- 34: Cap assembly
- 35: Battery cell
- 36: Endplate
- 36a: Fastening portion
- 36b: Bolt
- 37: Connection plate
- 38: Heat exchange member
- 39: Elastic member
- 41, 42: Busbar units
- 41a, 42a: Busbar plate
- 41b, 42b: Fastening portion
- 50: Venting slot
- 50a, 50b: Venting outlets
- 51, 52: Venting portions
- 60: Housing
- 61: Support plate
- 100: Longitudinal axis

## Claims

1. A battery module (1) comprising an electronic unit (20),
a cell connection unit (10),
wherein the cell connection unit (10) comprises:
- at least one substrate portion (13a, 13b, 13c) adapted to accommodate cell terminals (31, 32) of the battery module (1);
- a connector portion (11, 12, 14a, 14b, 14c, 15a, 15b, 15c) adapted to be connected to the electronic unit (20);
- an electronic circuit portion (10a, 10b) adapted to provide an electrical connection between at least one of the cell terminals (31, 32) of the battery module (1) and the electronic unit (20) via the connector portion (11, 12);
wherein the connector portion (11, 12, 14a, 14b, 14c, 15a, 15b, 15c) comprises at least one fixed electrical connector (11, 12) and a plurality of mechanical fixation connectors (14a, 14b, 14c, 15a, 15b, 15c);
wherein the at least one substrate portion (13a, 13b, 13c) comprises an opening portion (16) adapted to accommodate the electronic unit (20) and a venting portion (16a), wherein the venting portion (16a) has a longitudinal shape with one end facing the opening portion (16);
wherein the electronic unit (20) is connected to the cell connection unit (10) via the connector portion (11, 12, 14a, 14b, 14c, 15a, 15b, 15c); and
a venting slot (50) adapted to convey gas generated in the battery module (1) to the outside of the battery module (1) via at least one venting outlet (50a,50b), wherein the venting slot (50) extends along a longitudinal axis of the battery module (1); and
wherein the venting slot (50) is formed by the opening portion (16) and the venting portion (16a) of the cell connection unit (10),
**characterized in that**
the venting slot includes at least two venting outlets (50a, 50b) disposed at opposite ends of the venting slot (50).

2. The battery module (1) of claim 1, **characterized in that** the electronic unit (20) is a cell monitoring controller, CMC.

3. The battery module (1) of any one of claims 1 to 2, **characterized in that** the electronic unit (20) comprises a substrate (23) and at least one electronic component (27), wherein each one of the at least one electronic component (27) of the electronic unit (20) is arranged on one side of the substrate (23) facing the cell unit (30) of the battery module (1).

4. The battery module (1) of claim 1-3, wherein the cell connection unit (10) is **characterized in that** at least one of the fixed electrical connectors (11, 12) and the plurality of fixation connectors (14a, 14b, 14c, 15a, 15b, 15c) are press-fit connectors.

5. The battery module (1) of claim 1-4, wherein the cell connection unit (10) is **characterized in that** at least one of the fixed electrical connectors (11, 12) and the plurality of fixation connectors (14a, 14b, 14c, 15a, 15b, 15c) are pin connectors.

6. The battery module (1) of claim 1-5, **characterized in that** the cell connection unit (10) further comprises:
- at least one contact portion (18a, 18b) adapted to be electrically connected to the at least one of the cell terminals (31, 32) of the battery module (1),
wherein the at least one electronic circuit portion (10a, 10b) is adapted to electrically connect the at least one contact portion (18a, 18b) with the at least one fixed electrical connector (11, 12).

7. The battery module (1) of claim 1-6, wherein the cell connection unit (10) is **characterized in that** the electronic circuit portion (10a, 10b) is a built-in lead frame portion or an electric wiring portion integrated into the at least one substrate portion of the cell connection unit (10).

8. The battery module (1) of claim 1-7, wherein the cell connection unit (10) is **characterized in that** at least one contact portion (18a, 18b) is adapted to measure a voltage or temperature of the battery module (1).

9. The battery module (1) of claim 7 or 8 when depending on 7, wherein the cell connection unit (10) is **characterized in that** at least one substrate portion (13a, 13b, 13c) is one piece formed of the same material which includes the lead frame portion or the electric wiring.

10. The battery module (1) of claim 1-9, wherein the cell connection unit (10) is **characterized in that** at least a part (13c) of the at least one substrate portion (13a, 13b, 13c) exceeds the connector portion (11, 12, 14a, 14b, 14c, 15a, 15b, 15c) along a direction perpendicular to a plane of main extension of the cell connection unit (10).

## Patentansprüche

1. Ein Batteriemodul (1), aufweisend eine elektronische Einheit (20),
eine Zellverbindungseinheit (10),
wobei die Zellverbindungseinheit (10) aufweist:
- zumindest einen Substratabschnitt (13a, 13b, 13c), der angepasst ist, um Zellenanschlüsse (31, 32) des Batteriemoduls (1) aufzunehmen;
- einen Verbinderabschnitt (11, 12, 14a, 14b, 14c, 15a, 15b, 15c), der angepasst ist, um mit der elektronischen Einheit (20) verbunden zu sein;
- einen elektronischen Schaltungsabschnitt (10a, 10b), der angepasst ist, um über den Verbinderabschnitt (11, 12) eine elektrische Verbindung zwischen zumindest einem der Zellenanschlüsse (31, 32) des Batteriemoduls (1) und der elektronischen Einheit (20) bereitzustellen;
wobei der Verbinderabschnitt (11, 12, 14a, 14b, 14c, 15a, 15b, 15c) zumindest einen befestigten elektrischen Verbinder (11, 12) und eine Vielzahl mechanischer Befestigungsverbinder (14a, 14b, 14c, 15a, 15b, 15c) aufweist; wobei der zumindest eine Substratabschnitt (13a, 13b, 13c) einen Öffnungsabschnitt (16), der angepasst ist, um die elektronische Einheit (20) aufzunehmen, und einen Lüftungsabschnitt (16a) aufweist, wobei der Lüftungsabschnitt (16a) eine Längsform aufweist, wobei ein Ende dem Öffnungsabschnitt (16) zugewandt ist;
wobei die elektronische Einheit (20) über den Verbinderabschnitt (11, 12, 14a, 14b, 14c, 15a, 15b, 15c) mit der Zellverbindungseinheit (10) verbunden ist; und
einen Lüftungsschlitz (50), der angepasst ist, um Gas, das im Batteriemodul (1) erzeugt wird, über zumindest einen Lüftungsauslass (50a, 50b) zur Außenseite des Batteriemoduls (1) zu transportieren,
wobei sich der Lüftungsschlitz (50) entlang einer Längsachse des Batteriemoduls (1) erstreckt; und
wobei der Lüftungsschlitz (50) vom Öffnungsabschnitt (16) und vom Lüftungsabschnitt (16a) der Zellverbindungseinheit (10) ausgebildet wird,
**dadurch gekennzeichnet, dass**
der Lüftungsschlitz zumindest zwei Lüftungsauslässe (50a, 50b), die an gegenüberliegenden Enden des Lüftungsschlitzes (50) angeordnet sind, aufweist.

2. Das Batteriemodul (1) nach Anspruch 1, **dadurch gekennzeichnet, dass** die elektronische Einheit (20) eine Zellüberwachungssteuerung, CMC, ist.

3. Das Batteriemodul (1) nach einem der Ansprüche 1 bis 2, **dadurch gekennzeichnet, dass** die elektronische Einheit (20) ein Substrat (23) und zumindest eine elektronische Komponente (27) aufweist, wobei jede der zumindest einen elektronischen Komponente (27) der elektronischen Einheit (20) auf einer Seite des Substrats (23), das der Zelleneinheit (30) des Batteriemoduls (1) zugewandt ist, angeordnet ist.

4. Das Batteriemodul (1) nach Anspruch 1-3, wobei die Zellverbindungseinheit (10) **dadurch gekennzeichnet ist, dass** zumindest einer der befestigten elektrischen Verbinder (11, 12) und die Vielzahl der Befestigungsverbinder (14a, 14b, 14c, 15a, 15b, 15c) Einpressverbinder sind.

5. Das Batteriemodul (1) nach Anspruch 1-4, wobei die Zellverbindungseinheit (10) **dadurch gekennzeichnet ist, dass** zumindest einer der befestigten elektrischen Verbinder (11, 12) und die Vielzahl der Befestigungsverbinder (14a, 14b, 14c, 15a, 15b, 15c) Stiftverbinder sind.

6. Das Batteriemodul (1) nach Anspruch 1-5, **dadurch gekennzeichnet, dass** die Zellverbindungseinheit (10) ferner aufweist:
- zumindest einen Kontaktabschnitt (18a, 18b), der angepasst ist, um mit dem zumindest einen der Zellenanschlüsse (31, 32) des Batteriemoduls (1) elektrisch verbunden zu sein,
wobei der zumindest eine elektronische Schaltungsabschnitt (10a, 10b) angepasst ist, um den zumindest einen Kontaktabschnitt (18a, 18b) mit dem zumindest einen befestigten elektrischen Verbinder (11, 12) elektrisch zu verbinden.

7. Das Batteriemodul (1) nach Anspruch 1-6, wobei die Zellverbindungseinheit (10) **dadurch gekennzeichnet ist, dass** der elektronische Schaltungsabschnitt (10a, 10b) ein eingebauter Leiterrahmenabschnitt oder ein elektrischer Verdrahtungsabschnitt, der in den zumindest einen Substratabschnitt der Zellverbindungseinheit (10) integriert ist, ist.

8. Das Batteriemodul (1) nach Anspruch 1-7, wobei die Zellverbindungseinheit (10) **dadurch gekennzeichnet ist, dass** zumindest ein Kontaktabschnitt (18a, 18b) angepasst ist, um eine Spannung oder Temperatur des Batteriemoduls (1) zu messen.

9. Das Batteriemodul (1) nach Anspruch 7 oder 8, wenn dieser von Anspruch 7 abhängt, wobei die Zellverbindungseinheit (10) **dadurch gekennzeichnet ist, dass** zumindest ein Substratabschnitt (13a, 13b, 13c) ein Stück ist, das aus demselben Material, das den Leiterrahmenabschnitt oder die elektrische Verdrahtung aufweist, ausgebildet ist.

10. Das Batteriemodul (1) nach Anspruch 1-9, wobei die Zellverbindungseinheit (10) **dadurch gekennzeichnet ist, dass** zumindest ein Teil (13c) des zumindest einen Substratabschnitts (13a, 13b, 13c) den Verbinderabschnitt (11, 12, 14a, 14b, 14c, 15a, 15b, 15c) entlang einer Richtung perpendikulär zu einer Ebene der Haupterstreckung der Zellverbindungseinheit (10) übersteigt.

## Revendications

1. Module de batterie (1) comprenant une unité électronique (20),
une unité de raccordement d'élément (10),
où l'unité de raccordement d'élément (10) comprend :
- au moins une partie de substrat (13a, 13b, 13c) adaptée pour loger des bornes d'élément (31, 32) du module de batterie (1) ;
- une partie de connecteur (11, 12, 14a, 14b, 14c, 15a, 15b, 15c) adaptée pour être reliée à l'unité électronique (20) ;
- une partie de circuit électronique (10a, 10b) adaptée pour assurer une connexion électrique entre au moins l'une des bornes d'élément (31, 32) du module de batterie (1) et l'unité électronique (20) via la partie de connecteur (11, 12) ;
où la partie de connecteur (11, 12, 14a, 14b, 14c, 15a, 15b, 15c) comprend au moins un connecteur électrique fixe (11, 12) et une pluralité de connecteurs de fixation mécaniques (14a, 14b, 14c, 15a, 15b, 15c) ;
où l'au moins une partie de substrat (13a, 13b, 13c) comprend une partie d'ouverture (16) adaptée pour loger l'unité électronique (20) et une partie d'aération (16a), où la partie d'aération (16a) possède une forme longitudinale avec une extrémité tournée vers la partie d'ouverture (16) ;
où l'unité électronique (20) est reliée à l'unité de raccordement d'élément (10) via la partie de connecteur (11, 12, 14a, 14b, 14c, 15a, 15b, 15c) ; et
une fente d'aération (50) adaptée pour acheminer le gaz généré dans le module de batterie (1) vers l'extérieur du module de batterie (1) via au moins une sortie d'aération (50a, 50b),
où la fente d'aération (50) s'étend le long d'un axe longitudinal du module de batterie (1) ; et
où la fente d'aération (50) est formée par la partie d'ouverture (16) et la partie d'aération (16a) de l'unité de raccordement d'élément (10),
**caractérisé en ce que**
la fente d'aération comprend au moins deux sorties d'aération (50a, 50b) disposées aux extrémités opposées de la fente d'aération (50).

2. Module de batterie (1) selon la revendication 1, **caractérisé en ce que** l'unité électronique (20) est un contrôleur de surveillance d'élément, CMC.

3. Module de batterie (1) selon l'une quelconque des revendications 1 à 2, **caractérisé en ce que** l'unité électronique (20) comprend un substrat (23) et au moins un composant électronique (27), où chacun de l'au moins un composant électronique (27) de l'unité électronique (20) est prévu sur un côté du substrat (23) tourné vers l'unité d'élément (30) du module de batterie (1).

4. Module de batterie (1) selon les revendications 1 à 3, où l'unité de raccordement d'élément (10) est **caractérisée en ce qu'**au moins l'un des connecteurs électriques fixes (11, 12) et la pluralité de connecteurs de fixation (14a, 14b, 14c, 15a, 15b, 15c) sont des connecteurs à enfichage direct.

5. Module de batterie (1) selon les revendications 1 à 4, où l'unité de raccordement d'élément (10) est **caractérisée en ce qu'**au moins l'un des connecteurs électriques fixes (11, 12) et la pluralité de connecteurs de fixation (14a, 14b, 14c, 15a, 15b, 15c) sont des connecteurs à broche.

6. Module de batterie (1) selon les revendications 1 à 5, **caractérisé en ce que** l'unité de raccordement d'élément (10) comprend en outre :
- au moins une partie de contact (18a, 18b) adaptée pour être reliée électriquement à l'au moins une des bornes d'élément (31, 32) du module de batterie (1),
où l'au moins une partie de circuit électronique (10a, 10b) est adaptée pour relier électriquement l'au moins une partie de contact (18a, 18b) à l'au moins un connecteur électrique fixe (11, 12).

7. Module de batterie (1) selon les revendications 1 à 6, où l'unité de raccordement d'élément (10) est **caractérisée en ce que** la partie de circuit électronique (10a, 10b) est une partie de châssis de brochage intégrée ou une partie de câblage électrique intégrée à l'au moins une partie de substrat de l'unité de raccordement d'élément (10) .

8. Module de batterie (1) selon les revendications 1 à 7, où l'unité de raccordement d'élément (10) est **caractérisée en ce qu'**au moins une partie de contact (18a, 18b) est adaptée pour mesurer une tension ou une température du module de batterie (1).

9. Module de batterie (1) selon la revendication 7 ou 8 lorsqu'elle dépend de la revendication 7, où l'unité de raccordement d'élément (10) est **caractérisée en ce qu'**au moins une partie de substrat (13a, 13b, 13c) est une pièce formée du même matériau qui comprend la partie de châssis de brochage ou le câblage électrique.

10. Module de batterie (1) selon les revendications 1 à 9, où l'unité de raccordement d'élément (10) est **caractérisée en ce qu'**au moins une partie (13c) de l'au moins une partie de substrat (13a, 13b, 13c) dépasse la partie de connecteur (11, 12, 14a, 14b, 14c, 15a, 15b, 15c) le long d'une direction perpendiculaire à un plan d'extension principale de l'unité de raccordement d'élément (10) .
